# EUROPEAN PATENT APPLICATION

(11) **EP 4 565 035 A2**
(43) Date of publication of application: **04.06.2025**
(21) Application number: 24209759.0
(22) Date of filing: 30.10.2024
(51) Int. Cl.: H10D 89/10, G06F 30/392, H10D 84/01, H10D 89/00

(54) **INTEGRATED CIRCUIT INCLUDING BIAS CELLS AND METHOD OF MANUFACTURING THE SAME**

(30) Priority: 07.11.2023 KR 20230153101
(71) Applicant: Samsung Electronics Co., Ltd., Suwon-si, Gyeonggi-do 16677 (KR)
(72) Inventor: YOU, Hyeongyu, 16677 Suwon-si, Gyeonggi-do (KR); SEO, Jaewoo, 16677 Suwon-si, Gyeonggi-do (KR); NAM, Geonwoo, 16677 Suwon-si, Gyeonggi-do (KR); JEONG, Minjae, 16677 Suwon-si, Gyeonggi-do (KR); CHO, Jaehee, 16677 Suwon-si, Gyeonggi-do (KR)
(74) Representative: Kuhnen & Wacker Patent- und Rechtsanwaltsbüro PartG mbB

(57) **Abstract**

An integrated circuit may include: a plurality of wells (W51, W52) extending in parallel with each other in a first direction (X) on a substrate (SUB) having a first conductivity type, the plurality of wells (W51, W52) having a second conductivity type; a plurality of first doped regions (P11-P14, P21-P24) disposed on the plurality of wells (W51, W52) in a first region (R1) and a second region (R2), the first region (R1) being separated from the second region (R2) in the first direction (X), the plurality of first doped regions (P11-P14, P21-P24) having the first conductivity type; a plurality of second doped regions (N12, N13, N22, N23) disposed on the substrate (SUB) between the plurality of wells (W51, W52) in the first region (R1) and the second region (R2) and having the second conductivity type; and a plurality of third doped regions (P31-P34) disposed in a third region (R3) of the substrate (SUB) between the first region (R1) and the second region (R2) and having the first conductivity type.

## Description

### BACKGROUND

### 1. Field

The disclosure relates to an integrated circuit. Specifically, the disclosure relates to an integrated circuit including bias cells and a method of manufacturing the integrated circuit.

### 2. Description of Related Art

An integrated circuit may include not only devices such as transistors, but also a structure for driving the devices or preventing the occurrence of a leakage current. For example, an integrated circuit may include a structure for biasing a substrate or a well on which devices are disposed, and the substrate and the well may be biased. Due to advances in semiconductor processes, sizes of devices included in an integrated circuit may be reduced, and various limitations may occur due to the reduced sizes of devices.

### SUMMARY

In view of the foregoing concerns, an efficient structure for protecting or driving the devices may be desirable.

The disclosure provides an integrated circuit including bias cells for providing a reduced area and a method of manufacturing the integrated circuit.

According to an example embodiment of the disclosure, an integrated circuit may include: a plurality of wells extending in parallel with each other in a first direction on a substrate having a first conductivity type, the plurality of wells having a second conductivity type; a plurality of first doped regions disposed on the plurality of wells in a first region and a second region that are separated from each other in the first direction, the plurality of first doped regions having the first conductivity type; a plurality of second doped regions disposed on the substrate between the plurality of wells in the first region and the second region and having the second conductivity type; a plurality of third doped regions disposed in a third region of the substrate between the first region and the second region and having the first conductivity type; and a plurality of fourth doped regions disposed on the plurality of wells in the third region and having the second conductivity type. The third region may extend in a second direction perpendicular to the first direction.

According to an example embodiment of the disclosure, an integrated circuit may include: a plurality of functional cells disposed in a first region and a second region that are separated from each other in a first direction; and a series of bias cells disposed in a third region of the substrate between the first region and the second region, the third region extending in a second direction perpendicular to the first direction, wherein the series of bias cells may include: a plurality of first bias cells configured to bias a substrate and having a first conductivity type; and a plurality of second bias cells configured to bias a plurality of wells extending on the substrate in parallel with each other in the first direction and having a second conductivity type, wherein the plurality of first bias cells and the plurality of second bias cells are alternately disposed in the second direction.

According to an example embodiment of the disclosure, a method of manufacturing an integrated circuit, the method may include: placing bias cells for biasing a substrate and a plurality of wells, the substrate having a first conductivity type and the plurality of wells extending on the substrate in parallel with each other in a first direction and having a second conductivity type; and placing, based on input data, functional cells in a region in which the bias cells are not placed. The placing of the bias cells may include alternately placing a plurality of first bias cells biasing the substrate and a plurality of second bias cells biasing the plurality of wells in a second direction perpendicular to the first direction.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a plan view of a layout of an integrated circuit according to one or more embodiments;
FIG. 2A is a cross-sectional view of an example of a layout of an integrated circuit, according to one or more embodiments;
FIG. 2B is a cross-sectional view of an example of a layout of an integrated circuit, according to one or more embodiments;
FIG. 3A is a view of an example of a device, according to one or more embodiments;
FIG. 3B is a view of an example of a device, according to one or more embodiments;
FIG. 3C is a view of an example of a device, according to one or more embodiments;
FIG. 3D is a view of an example of a device, according to one or more embodiments;
FIG. 4 is a view schematically showing a process of forming doped regions, according to one or more embodiments;
FIG. 5A is a plan view of doping regions according to one or more embodiments;
FIG. 5B is a plan view of a layout of an integrated circuit according to one or more embodiments;
FIG. 6A is a plan view of doping regions according to one or more embodiments;
FIG. 6B is a plan view of a layout of an integrated circuit according to one or more embodiments;
FIG. 7 is a plan view of doping regions according to one or more embodiments;
FIG. 8 is a plan view of a layout of an integrated circuit according to one or more embodiments;
FIG. 9 is a flowchart of a method of manufacturing an integrated circuit, according to one or more embodiments;
FIG. 10 is a flowchart of a method of manufacturing an integrated circuit, according to one or more embodiments;
FIG. 11 is a block diagram of a system on chip (SoC) according to one or more embodiments; and
FIG. 12 is a block diagram of a computing system including a memory storing a program, according to one or more embodiments.

### DETAILED DESCRIPTION

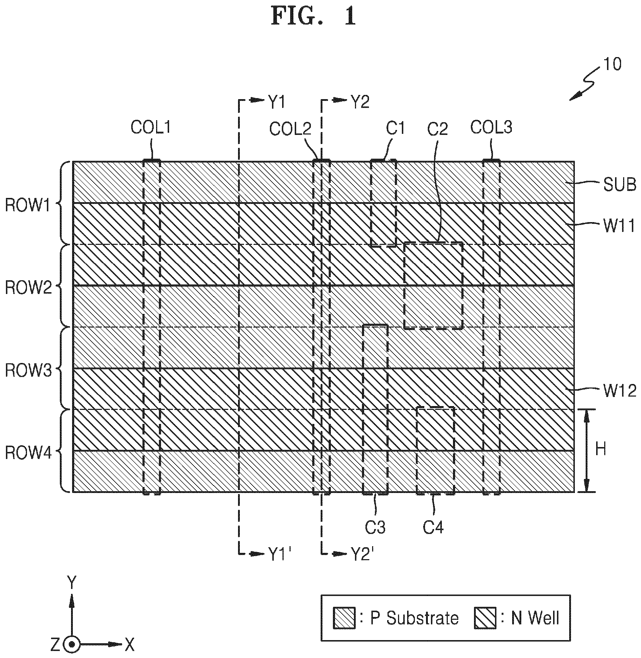

FIG. 1 is a plan view of a layout 10 of an integrated circuit according to one or more embodiments. For example, the plan view of FIG. 1 shows the layout 10 corresponding to a portion of the integrated circuit in a plane defined by an X axis and a Y axis.

Herein, an X-axis direction and a Y-axis direction may respectively be referred to as a first direction and a second direction, and a Z-axis direction may be referred to as a vertical direction or a third direction. The plane defined by the X axis and the Y axis may be referred to as a horizontal plane. An element relatively more shifted in a +Z direction than other elements may be referred to as being placed above the other elements, and an element relatively more shifted in a -Z direction than other elements may be referred to as being placed below the other elements. Also, an area of an element may refer to a size occupied by the element in a plane parallel to the horizontal plane, and a width of the element may refer to a length of the element in a direction intersecting a direction in which the element extends. A surface exposed in the +Z direction may be referred to as a top surface, a surface exposed in the -Z direction may be referred to as a bottom surface, and a surface exposed in a ±X direction or a ±Y direction may be referred to as a side surface. In the drawings, for convenience of illustration, only some of layers may be illustrated.

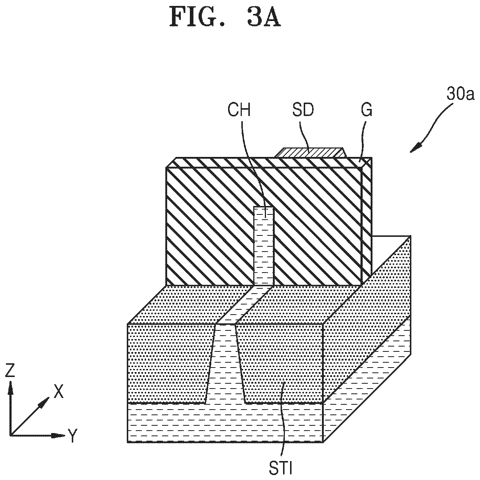

Referring to FIG. 1, the layout 10 may include a substrate SUB and may include a first well W11 and a second well W12 extending on the substrate SUB in parallel with each other in an X-axis direction. Devices, for example, transistors, may be disposed on the substrate SUB, the first well W11, and the second well W12, and patterns for connecting the transistors to each other may be disposed above the transistors. Examples of the transistors will be described below with reference to FIGS. 3A to 3D. According to some embodiments, the integrated circuit may include backside patterns placed below the substrate SUB and may include vias connecting the backside patterns to the devices and/or to the patterns placed above the devices, for example, through silicon vias (TSVs). Herein, it is assumed that the substrate SUB may be doped with a P-type material and the wells may be doped with an N-type material. However, embodiments are not limited thereto.

The integrated circuit may include a plurality of cells. For example, as illustrated in FIG. 1, the layout 10 may include a first cell C1 placed in a first row ROW1, a second cell C2 placed in a second row ROW2, a third cell C3 consecutively placed in a third row ROW3 and a fourth row ROW4 and a fourth cell C4 placed in the fourth row ROW4. The first row ROW1, the second row ROW2, the third row ROW3, and the fourth row ROW4 may extend in the X-axis direction and may have a height H. According to some embodiments, the rows may have different heights from each other. The cell may be a unit of the layout that is included in the integrated circuit and may be referred to as a standard cell. The cell may include a transistor and may be designed to perform a pre-defined function. The cell placed in one row, such as the first cell C1, the second cell C2, and the fourth cell C4, may be referred to as a single-height cell and may have the height H. The cell consecutively placed in two or more rows, such as the third cell C3, may be referred to as a multi-height cell.

N-channel field-effect transistors (NFETs) may be placed on the substrate SUB, and P-channel field-effect transistors (PFETs) may be placed on the first well W11 and the second well W12. As illustrated in FIG. 1, the cell may overlap the substrate SUB and the well, and thus, the cell may include the NFET placed on the substrate SUB and the PFET placed on the well. In order to drive the NFET, the substrate SUB may be biased to a negative supply voltage (which may be referred to as a first supply voltage herein), and in order to drive the PFET included in the cell, the first well W11 and the second well W12 may be biased to a positive supply voltage (which may be referred to as a second supply voltage herein).

The integrated circuit may include cells to bias the substrate SUB, the first well W11, and the second well W12, and the cells may be regularly placed in the layout 10. For example, as illustrated in FIG. 1, the layout 10 may include a series of cells placed in a first column COL1, a second column COL2, and a third column COL3 and biasing the substrate SUB, the first well W11, and/or the second well W12. Herein, the cells biasing the substrate SUB and/or the wells may be referred to as bias cells, and the cells (for example, the first to fourth cells C1 to C4) except for the bias cells may be referred to as functional cells. The bias cell may provide a supply voltage for driving the transistors and may prevent latch-up to prevent the occurrence of a leakage current.

As described above with reference to the drawings, the bias cell may have a reduced width, that is, a length in the X-axis direction. Accordingly, a width, that is, a length in the X-axis direction, of each of the first column COL1, the second column COL2, and the third column COL3 may be decreased, an area of the layout 10 may be reduced, and the efficiency of the integrated circuit may be improved. Also, the bias cell may have a simple structure, and thus, the cost of the integrated circuit may be reduced, and a yield of the integrated circuit may be improved.

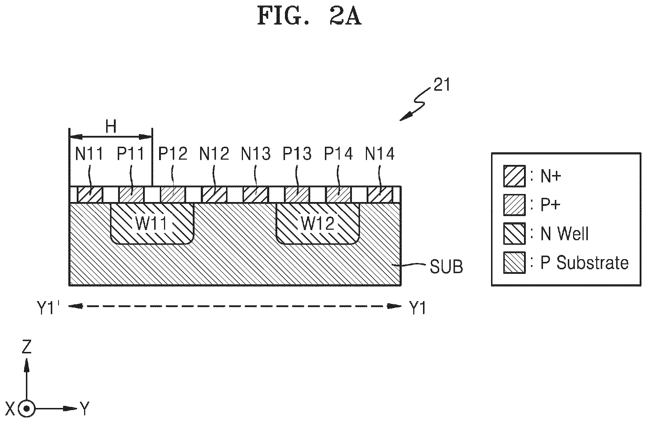

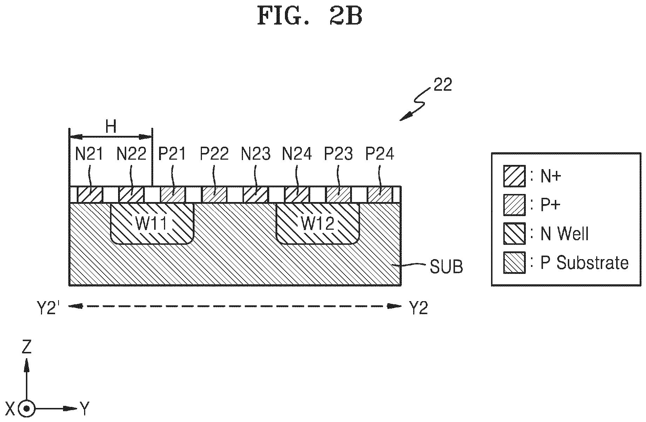

FIGS. 2A and 2B are cross-sectional views of examples of a layout of an integrated circuit, according to embodiments. For example, the cross-sectional view of FIG. 2A shows an example of a cross-section of the layout 10 of FIG. 1, taken along line Y1-Y1', and the cross-sectional view of FIG. 2B shows an example of the cross-section of the layout 10 of FIG. 1, taken along line Y2-Y2'. Hereinafter, FIGS. 2A and 2B are described by referring to FIG. 1, and in the descriptions with respect to FIGS. 2A and 2B, the same aspects are not repeatedly described.

Referring to FIG. 2A, a layout 21 may include a substrate SUB and may include a first well W11 and a second well W12 extending on the substrate SUB in parallel with each other in an X-axis direction. As described above with reference to FIG. 1, NFETs may be placed on the substrate SUB, and PFETs may be placed on the first well W11 and the second well W12. Accordingly, N+ regions corresponding to sources/drains of the NFETs may be disposed on the substrate SUB, and P+ regions corresponding to sources/drains of the PFETs may be disposed on the first well W11 and the second well W12. For example, as illustrated in FIG. 2A, a first N+ region N11, a second N+ region N12, a third N+ region N13, and a fourth N+ region N14 may be disposed on the substrate SUB, and a first P+ region P11, a second P+ region P12, a third P+ region P13, and a fourth P+ region P14 may be disposed on the first well W11 and the second well W12. According to some embodiments, the P+ region may have a higher doping concentration than the substrate SUB, and the N+ region may have a higher doping concentration than the first well W11 and the second well W12. Herein, the N+ region may be referred to as an N-type doped region, the P+ region may be referred to as a P-type doped region, and the N+ region and the P+ region may be collectively referred to as a doped region.

Referring to FIG. 2B, a layout 22 may include a substrate SUB and may include a first well W11 and a second well W12 extending on the substrate SUB in parallel with each other in an X-axis direction. As described above with reference to FIG. 1, a bias cell may be placed in a second column COL2, and the bias cell may bias the substrate SUB, the first well W11, or the second well W12. The conductivity type of the substrate SUB may be a P-type, and a P+ region may be disposed on the substrate SUB to bias the substrate SUB. For example, as illustrated in FIG. 2B, a second P+ region P22 and a fourth P+ region P24 may be disposed on the substrate SUB, and a negative supply voltage may be applied to the second P+ region P22 and the fourth P+ region P24. Also, the conductivity types of the first well W11 and the second well W12 may be N-types, and an N+ region may be disposed on the first well W11 and the second well W12 to bias the first well W11 and the second well W12. For example, as illustrated in FIG. 2B, a second N+ region N22 and a fourth N+ region N24 may be disposed on the first well W11 and the second well W12, and a positive supply voltage may be applied to the second N+ region N22 and the fourth N+ region N24.

According to some embodiments, contacts and/or vias may be placed in the second P+ region P22 and the fourth P+ region P24, and the contacts and/or the vias may be connected to patterns of a wiring layer providing a negative supply voltage. According to some embodiments, TSVs passing through the substrate may be placed in the second P+ region P22 and the fourth P+ region P24, and the TSVs may be connected to patterns of a backside wiring layer providing a negative supply voltage. According to some embodiments, contacts may be placed in the second N+ region N22 and the fourth N+ region N24, and vias may be placed on the contacts, wherein the vias may be connected to patterns of a wiring layer providing a positive supply voltage. According to some embodiments, TSVs passing through the substrate may be placed in the second N+ region N22 and the fourth N+ region N24, and the TSVs may be connected to patters of a backside wiring layer providing a positive supply voltage.

According to some embodiments, the bias cell not only may include the doped region to bias the substrate SUB and the well, but also may include an additional doping region. For example, as illustrated in FIG. 2B, a first N+ region N21 and a third N+ region N23 disposed on the substrate SUB may be disposed in the second column COL2, and a first P+ region P21 disposed on the first well W11 and a third P+ region P23 disposed on the second well W12 may be disposed in the second column COL2. According to some embodiments, the additional doping region may be removed from the bias cell. For example, the first N+ region N21, the first P+ region P21, the third N+ region N23, and the third P+ region P23 of FIG. 2B may be removed after being formed by a semiconductor process.

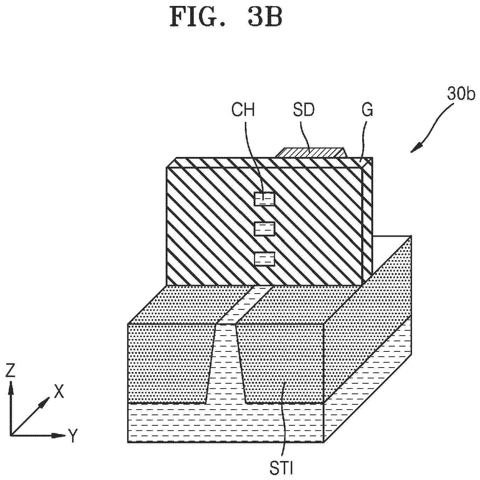

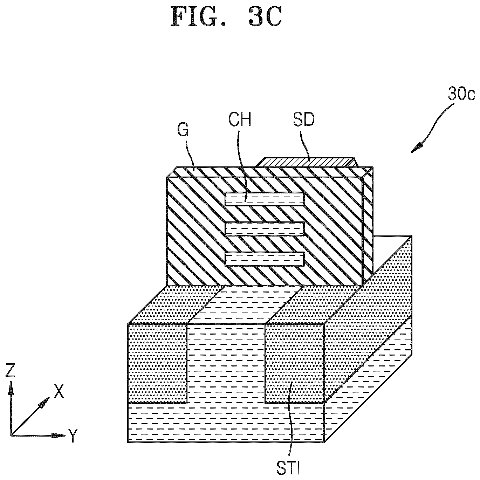

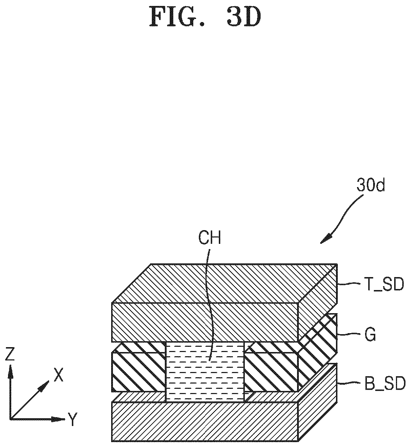

FIGS. 3A to 3D are views of examples of a device, according to embodiments. For example, FIG. 3A shows a Fin field-effect transistor (FinFET) 30a, FIG. 3B shows a gate-all-around field-effect transistor (GAAFET) 30b, FIG. 3C shows a multi-bridge channel field-effect transistor (MBCFET) 30c, and FIG. 3D shows a vertical field-effect transistor (VFET) 30d. For convenience of illustration, FIGS. 3A to 3C illustrate a shape in which one of source/drain regions is removed, and FIG. 3D illustrates a cross-section of the VFET 30d taken along a plane passing through a channel CH of the VFET 30d and parallel with a plane defined by a Y axis and a Z axis.

Referring to FIG. 3A, the FinFET 30a may be formed by an active pattern having a fin shape extending in an X-axis direction between shallow trench isolations (STIs) and a gate electrode G extending in a Y-axis direction. The source/drain regions SD may be formed at both sides of the gate electrode G, and thus, the source and the drain may be apart from each other in the X-axis direction. An insulating layer may be formed between a channel CH and the gate electrode G. According to some embodiments, the FinFET 30a may be formed by a plurality of active patterns apart from each other in a Y-axis direction and the gate electrode G and may have an extended channel.

Referring to FIG. 3B, the GAAFET 30b may be formed by active patterns apart from each other in a Z-axis direction and extending in an X-axis direction, that is, nanowires, and a gate electrode G extending in a Y-axis direction. The source/drain regions SD may be formed at both sides of the gate electrode G, and thus, the source and the drain may be apart from each other in the X-axis direction. An insulating layer may be formed between a channel CH and the gate electrode G. It may be noted that the number of nanowires included in the GAAFET 30b is not limited to the number illustrated in FIG. 3B.

Referring to FIG. 3C, the MBCFET 30c may be formed by active patterns apart from each other in a Z-axis direction and extending in an X-axis direction, that is, nanosheets, and a gate electrode G extending in a Y-axis direction. The source/drain regions SD may be formed at both sides of the gate electrode G, and thus, the source and the drain may be apart from each other in the X-axis direction. An insulating layer may be formed between a channel CH and the gate electrode G. It may be noted that the number of nanosheets included in the MBCFET 30c is not limited to the number illustrated in FIG. 3C.

Referring to FIG. 3D, the VFET 30d may include top source/drain regions T_SD and bottom source/drain regions B_SD that are apart from each other in a Z-axis direction with the channel CH therebetween. The VFET 30d may include a gate electrode G surrounding the circumference of the channel CH between the top source/drain regions T_SD and the bottom source/drain regions B_SD. An insulating layer may be formed between the channel CH and the gate electrode G.

Hereinafter, an integrated circuit including the FinFET 30a or the MBCFET 30c will be mainly described. However, it may be noted that the devices included in the integrated circuit are not limited to the examples of FIGS. 3A to 3D. For example, the integrated circuit may include a Fork field-effect transistor (ForkFET) in which nanosheets for a P-type transistor and nanosheets for an N-type transistor are separated from each other by a dielectric wall, so that the N-type transistor and the P-type transistor may have a structure having increased proximity. Also, the integrated circuit may include not only FETs, such as a complementary field-effect transistor (CFET), a negative capacitance field-effect transistor (NCFET), a carbon nanotube (CNT) FET, etc., but also a bipolar junction transistor.

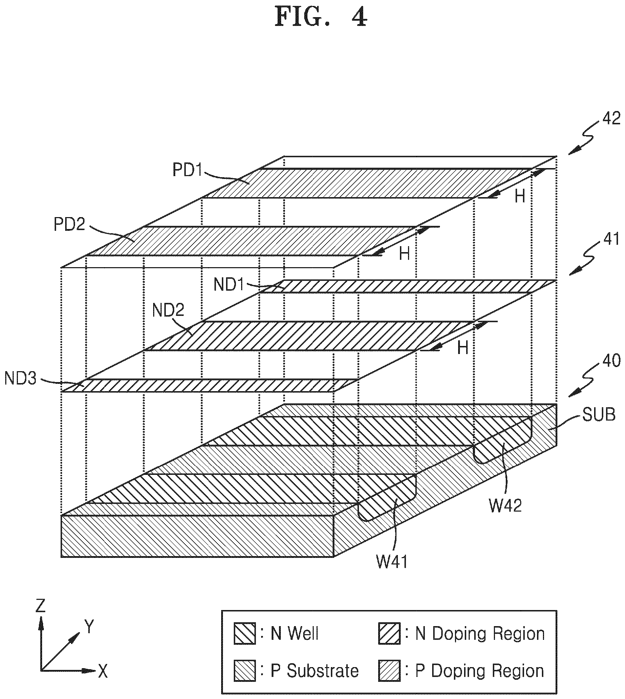

FIG. 4 is a view schematically showing a process of forming doped regions, according to one or more embodiments. For example, FIG. 4 shows a process of forming doped regions in a layout 40 in which functional cells are disposed. As described above with reference to the drawings, N+ regions corresponding to the sources/drains of the NFETs may be disposed on the substrate SUB, and P+ regions corresponding to the sources/drains of the PFETs may be disposed on the wells.

Referring to FIG. 4, the layout 40 may include a substrate SUB and a first well W41 and a second well W42 extending on the substrate SUB in parallel with each other in an X-axis direction. A first sub-process 41 for forming the N+ regions on the substrate SUB may be performed on the layout 40. For example, as illustrated in FIG. 4, the first sub-process 41 may form the N+ regions in a first N-doping region ND1, a second N-doping region ND2, and a third N-doping region ND3 which correspond to an upper surface of the substrate SUB exposed in a +Z-axis direction, for example, through implanting. Also, a second sub-process 42 for forming the P+ regions on the wells may be performed on the layout 40. For example, as illustrated in FIG. 4, the second sub-process 42 may form, for example, by implanting, the P+ regions in a first P-doping region PD1 and a second P-doping region PD2 corresponding to the first well W41 and the second well W42. Each of the doped regions formed by the first sub-process 41 and the second sub-process 42 may be split into a plurality of doped regions or may be partially removed by subsequent processes. Herein, regions doped with impurities by the sub-process to form the doped regions in the layout may be referred to as doping regions.

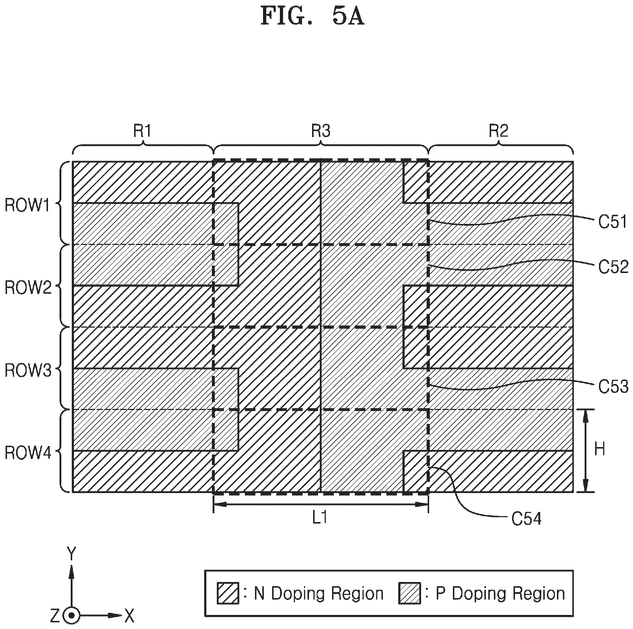

As illustrated in FIG. 4, the doping regions may have a width corresponding to a height H of a row (or a single-height cell), that is, a length in a Y-axis direction. As the sizes of transistors included in an integrated circuit are reduced, sizes of cells may be reduced and the height H of a row may be reduced. Due to semiconductor processes, it is difficult and/or expensive to make a doping region having a width that is less than its height H. Accordingly, as described below with reference to FIGS. 5A, 6A, and 7, doping regions for forming the P+ regions disposed on the substrate SUB and the N+ regions disposed on the wells, that is, the doped regions included in the bias cells, may be useful.

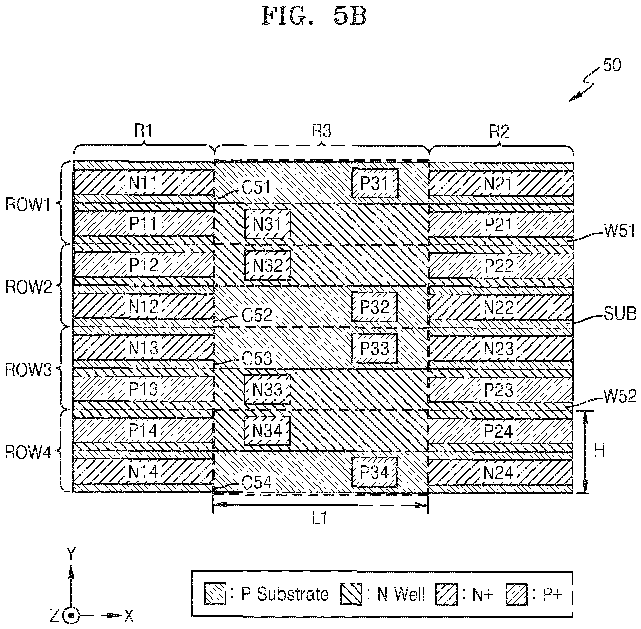

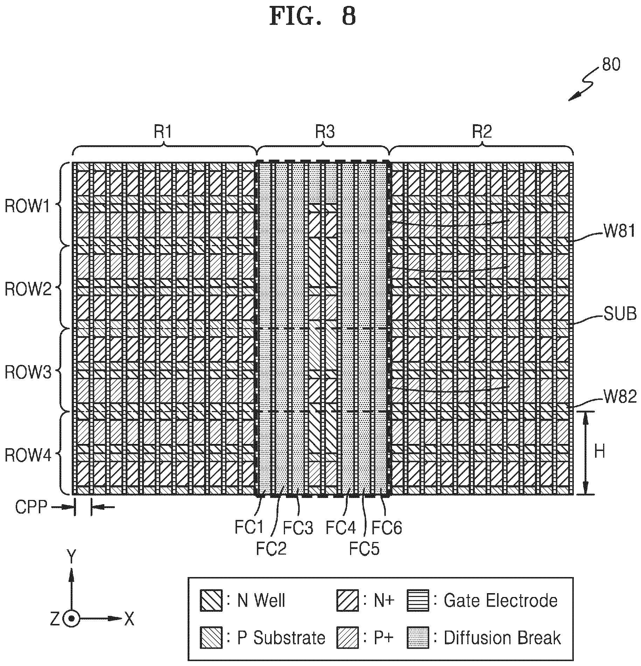

FIG. 5A is a plan view of doping regions according to one or more embodiments, and FIG. 5B is a plan view of a layout 50 of an integrated circuit according to one or more embodiments. For example, the plan view of FIG. 5A shows the doping regions for forming the doped regions in the layout 50 of the integrated circuit, and FIG. 5B shows the layout 50 including the doped regions formed by the doping regions of FIG. 5A. For convenience of illustration, while FIG. 5B illustrates the doped regions extending in an X-axis direction, each of the doped regions may be split into a plurality of doped regions or may be partially removed by subsequent processes. Also, as described below with reference to FIG. 8, each of the doped regions may be separated by a diffusion break and/or a gate electrode extending in a Y-axis direction. Hereinafter, in the descriptions with respect to FIGS. 5A and 5B, the same aspects are not repeatedly described.

Referring to FIG. 5A, a first row ROW1, a second row ROW2, a third row ROW3, and a fourth row ROW4 may extend in the X-axis direction. Functional cells may be disposed in a first region R1 and a second region R2, and bias cells may be disposed in a third region R3 between the first region R1 and the second region R2. The first region R1 and the second region R2 are separated from each other in the X-axis direction. For example, a first bias cell C51, a second bias cell C52, a third bias cell C53, and a fourth bias cell C54 may be placed in the first row ROW1, the second row ROW2, the third row ROW3, and the fourth row ROW4, respectively. As described above with reference to FIG. 4, manufacturing may be difficult when the doping region has a width that is less than its height H. Accordingly, as illustrated in FIG. 5A, each of the N-doping region and the P-doping region may have a shape which has lengths in the X-axis direction and the Y-axis direction, the lengths being greater than or equal to the height H. A length of the third region R3 in the X-axis direction, that is, a width of the first bias cell C51, the second bias cell C52, the third bias cell C53, and the fourth bias cell C54 may correspond to a first length L1.

Referring to FIG. 5B, the layout 50 may include a substrate SUB and a first well W51 and a second well W52 extending on the substrate SUB in parallel with each other in the X-axis direction. Also, the layout 50 may include the doped regions formed by the doping regions of FIG. 5A. For example, as illustrated in FIG. 5B, the layout 50 may include a first N+ region N11, a second N+ region N12, a third N+ region N13, a fourth N+ region N14, a first P+ region P11, a second P+ region P12, a third P+ region P13, and a fourth P+ region P14, which are disposed in the first region R1. Also, the layout 50 may include a first N+ region N21, a second N+ region N22, a third N+ region N23, a fourth N+ region N24, a first P+ region P21, a second P+ region P22, a third P+ region P23, and a fourth P+ region P24, which are disposed in the second region R2. Also, the layout 50 may include a first N+ region N31, a second N+ region N32, a third N+ region N33, a fourth N+ region N34, a first P+ region P31, a second P+ region P32, a third P+ region P33, and a fourth P+ region P34, which are disposed in the third region R3.

According to some embodiments, the first N+ region N31, the second N+ region N32, the third N+ region N33, and the fourth N+ region N34 which are disposed in the third region R3 respectively may be aligned with (or overlap), in the X-axis direction, the first P+ region P11, the second P+ region P12, the third P+ region P13, and the fourth P+ region P14 which are disposed in the first region R1 and respectively may be aligned with (or overlap), in the X-axis direction, the first P+ region P21, the second P+ region P22, the third P+ region P23, and the fourth P+ region P24 which are disposed in the second region R2. According to some embodiments, the first P+ region P31, the second P+ region P32, the third P+ region P33, and the fourth P+ region P34 which are disposed in the third region R3 respectively may be aligned with (or overlap), in the X-axis direction, the first N+ region N11, the second N+ region N12, the third N+ region N13, and the fourth N+ region N14 which are disposed in the first region R1 and respectively may be aligned with (or overlap), in the X-axis direction, the first N+ region N21, the second N+ region N22, the third N+ region N23, and the fourth N+ region N24 which are disposed in the second region R2.

While the N+ regions and the P+ regions disposed in the first region R1 and the second region R2 may correspond to the source/drain regions of the transistors, the N+ regions and the P+ regions disposed in the third region R3 may correspond to the N+ regions and the P+ regions to bias the substrate SUB and the well. For example, the first bias cell C51 may include the first P+ region P31 to bias the substrate SUB and the first N+ region N31 to bias the first well W51. The second bias cell C52 may include the second N+ region N32 to bias the first well W51 and the second P+ region P32 to bias the substrate SUB. The third bias cell C53 may include the third P+ region P33 to bias the substrate SUB and the third N+ region N33 to bias the second well W52. The fourth bias cell C54 may include the fourth N+ region N34 to bias the second well W52 and the fourth P+ region P34 to bias the substrate SUB. While a positive supply voltage may be applied to the first N+ region N31, the second N+ region N32, the third N+ region N33, and the fourth N+ region N34 which are disposed in the third region R3, a negative supply voltage may be applied to the first P+ region P31, the second P+ region P32, the third P+ region P33, and the fourth P+ region P34 which are disposed in the third region R3. In the example of FIGS. 5A and 5B, one bias cell may include both of the P+ region to bias the substrate SUB and the N+ region to bias the well.

According to some embodiments, the N+ regions and/or the P+ regions of the first region R1 and/or the second region R2 may extend to the third region R3. For example, at least one of the first to fourth N+ regions N11 to N14 of the first region R1 and the first to fourth N+ regions N21 to N24 of the second region R2 may extend in the X-axis direction to be near to at least one of the first to fourth P+ regions P31 to P34 of the third region R3. Also, at least one of the first to fourth P+ regions P11 to P14 of the first region R1 and the first to fourth P+ regions P21 to P24 of the second region R2 may extend in the X-axis direction to be near to at least one of the first to fourth N+ regions N31 to N34 of the third region R3. As described above, the extended N+ region and P+ region may be separated by a diffusion break and/or a gate electrode extending in the Y-axis direction.

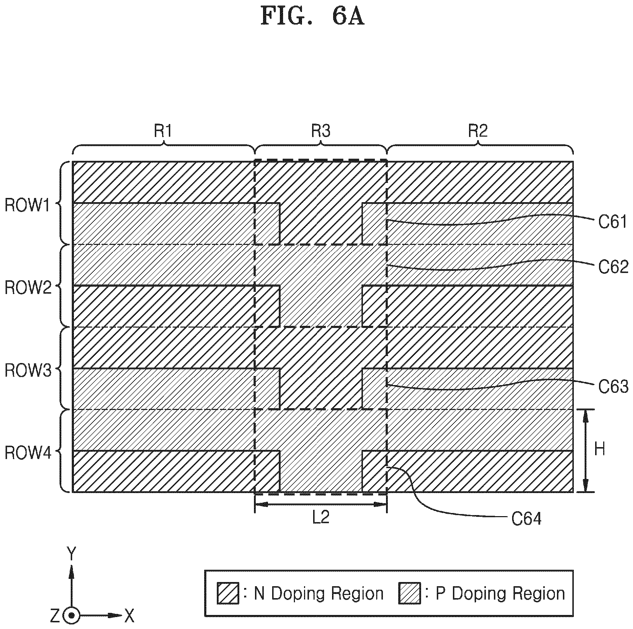

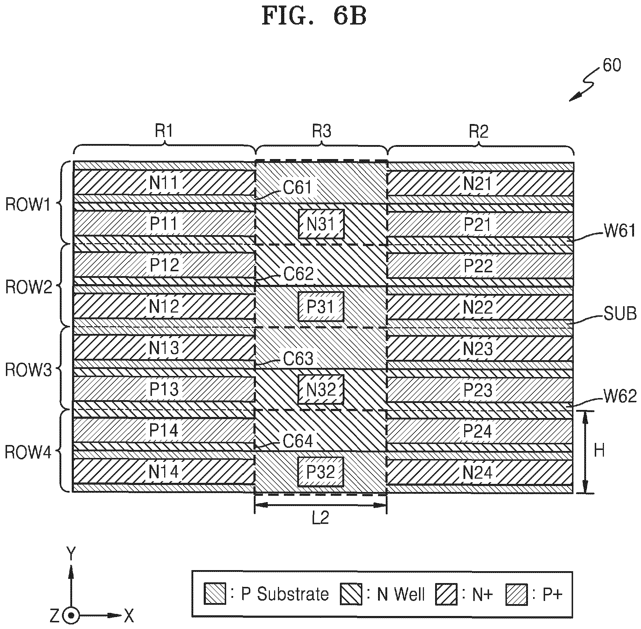

FIG. 6A is a plan view of doping regions according to one or more embodiments, and FIG. 6B is a plan view of a layout 60 of an integrated circuit according to one or more embodiments. For example, the plan view of FIG. 6A shows doping regions for forming doped regions in the layout 60 of the integrated circuit, and FIG. 6B shows the layout 60 including the doped regions formed by the doping regions of FIG. 6A. For convenience of illustration, while FIG. 6B illustrates the doped regions extending in an X-axis direction, each of the doped regions may be split into a plurality of doped regions or partially removed by subsequent processes. Also, as described below with reference to FIG. 8, each of the doped regions may be separated by a diffusion break and/or a gate electrode extending in a Y-axis direction. Hereinafter, in the descriptions with respect to FIGS. 6A and 6B, the same aspects are not repeatedly described.

Referring to FIG. 6A, a first row ROW1, a second row ROW2, a third row ROW3, and a fourth row ROW4 may extend in the X-axis direction. Functional cells may be disposed in a first region R1 and a second region R2, and bias cells may be disposed in a third region R3 between the first region R1 and the second region R2. For example, a first bias cell C61, a second bias cell C62, a third bias cell C63, and a fourth bias cell C64 may be placed in the first row ROW1, the second row ROW2, the third row ROW3, and the fourth row ROW4, respectively. As described above with reference to FIG. 4, it may not be easy to make the width of the doping region less than a height H. Accordingly, as illustrated in FIG. 6A, each of an N-doping region and a P-doping region may have a shape which has lengths in the X-axis direction and the Y-axis direction, the lengths being greater than or equal to the height H. A length of the third region R3 in the X-axis direction, that is, a width of the first bias cell C61, the second bias cell C62, the third bias cell C63, and the fourth bias cell C64 may correspond to a second length L2, and the second length L2 may be less than the first length L1 of FIGS. 5A and 5B.

Referring to FIG. 6B, the layout 60 may include a substrate SUB and a first well W61 and a second well W62 extending on the substrate SUB in parallel with each other in the X-axis direction. Also, the layout 60 may include the doped regions formed by the doping regions of FIG. 6A. For example, as illustrated in FIG. 6B, the layout 60 may include a first N+ region N11, a second N+ region N12, a third N+ region N13, a fourth N+ region N14, a first P+ region P11, a second P+ region P12, a third P+ region P13, and a fourth P+ region P14, which are disposed in the first region R1. Also, the layout 60 may include a first N+ region N21, a second N+ region N22, a third N+ region N23, a fourth N+ region N24, a first P+ region P21, a second P+ region P22, a third P+ region P23, and a fourth P+ region P24, which are disposed in the second region R2. Also, the layout 60 may include a first N+ region N31, a second N+ region N32, a first P+ region P31, and a second P+ region P32 which are disposed in the third region R3. As illustrated in FIG. 6B, the first N+ region N31, the second N+ region N32, the first P+ region P31, and the second P+ region P32 may be aligned (or overlap) in the Y-axis direction in the third region R3. The third region may extend in the Y-axis direction.

According to some embodiments, the first N+ region N31 and the second N+ region N32 which are disposed in the third region R3 respectively may be aligned with (or overlap), in the X-axis direction, the first P+ region P11 and the third P+ region P13 which are disposed in the first region R1 and respectively may be aligned with (or overlap), in the X-axis direction, the first P+ region P21 and the third P+ region P23 which are disposed in the second region R2. According to some embodiments, the first P+ region P31 and the second P+ region P32 which are disposed in the third region R3 respectively may be aligned with (or overlap), in the X-axis direction, the second N+ region N12 and the fourth N+ region N14 which are disposed in the first region R1 and respectively may be aligned with (or overlap), in the X-axis direction, the second N+ region N22 and the fourth N+ region N24 which are disposed in the second region R2.

While the N+ regions and the P+ regions disposed in the first region R1 and the second region R2 may correspond to the source/drain regions of the transistors, the N+ regions and the P+ regions disposed in the third region R3 may correspond to the N+ regions and the P+ regions to bias the substrate SUB and the well. For example, the first bias cell C61 may include the first N+ region N31 to bias the first well W61. The second bias cell C62 may include the first P+ region P31 to bias the substrate SUB. The third bias cell C63 may include the second N+ region N32 to bias the second well W62. The fourth bias cell C64 may include the second P+ region P32 to bias the substrate SUB. While a positive supply voltage may be applied to the first N+ region N31 and the second N+ region N32 which are disposed in the third region R3, a negative supply voltage may be applied to the first P+ region P31 and the second P+ region P32 which are disposed in the third region R3.

In the example of FIGS. 6A and 6B, one bias cell may include the P+ region to bias the substrate SUB or the N+ region to bias the well. Accordingly, the bias cells to bias the substrate SUB and the bias cells to bias the wells may be alternately disposed in the Y-axis direction in the third region. For example, while the first bias cell C61 and the third bias cell C63 placed in the first row ROW1 and the third row ROW3, respectively, may bias the first well W61 and the second well W62, respectively, the second bias cell C62 and the fourth bias cell C64 placed in the second row ROW2 and the fourth row ROW4, respectively, may bias the substrate SUB. Due to the second length L2 which is less than the first length L1 of FIGS. 5A and 5B, the layout 60 may have a reduced area compared to the layout 50 of FIG. 5B.

According to some embodiments, the N+ region and/or the P+ region of the first region R1 and/or the second region R2 may extend to the third region R3. For example, the first N+ region N11 and the third N+ region N13 of the first region R1 may extend in the X-axis direction and the first N+ region N21 and the third N+ region N23 of the second region R2 may extend in the X-axis direction, and the first N+ region N11 and the third N+ region N13 of the first region R1 may be connected to the first N+ region N21 and the third N+ region N23 of the second region R2, respectively, in the third region R3. Also, at least one of the second N+ region N12 and the fourth N+ region N14 of the first region R1 and the second N+ region N22 and the fourth N+ region N24 of the second region R2 may extend in the X-axis direction to be near to at least one of the first P+ region P31 and the second P+ region P32 of the third region R3. For example, the second P+ region P12 and the fourth P+ region P14 of the first region R1 may extend in the X-axis direction and the second P+ region P22 and the fourth P+ region P24 of the second region R2 may extend in the X-axis direction, and the second P+ region P12 and the fourth P+ region P14 of the first region R1 may be connected to the second P+ region P22 and the fourth P+ region P24 of the second region R2, respectively, in the third region R3. Also, at least one of the first P+ region P11 and the third P+ region P13 of the first region R1 and the first P+ region P21 and the third P+ region P23 of the second region R2 may extend in the X-axis direction to be near to at least one of the first N+ region N31 and the second N+ region N32 of the third region R3. As described above, the extended N+ region and P+ region may be separated by a diffusion break and/or a gate electrode extending in the Y-axis direction.

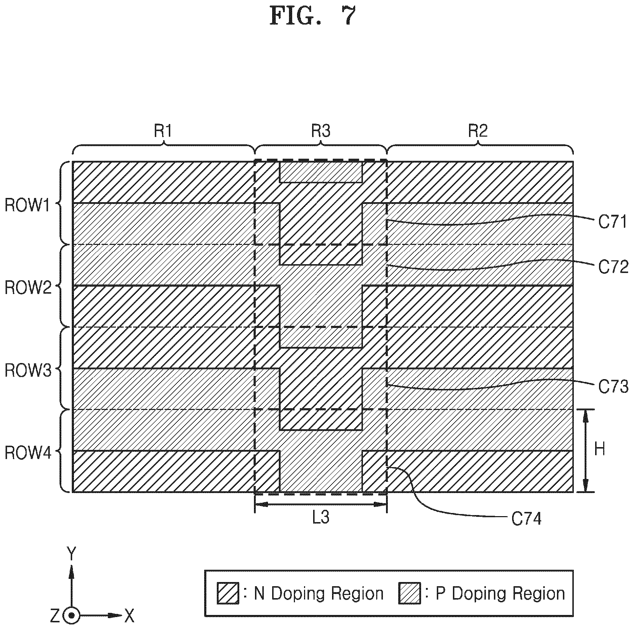

FIG. 7 is a plan view of doping regions according to one or more embodiments. For example, the plan view of FIG. 7 shows the doping regions for forming the doped regions of the layout 60 of FIG. 6B. Hereinafter, FIG. 7 is described below with reference to FIGS. 6A and 6B.

Referring to FIG. 7, a first row ROW1, a second row ROW2, a third row ROW3, and a fourth row ROW4 may extend in an X-axis direction. Functional cells may be disposed in a first region R1 and a second region R2, and bias cells may be disposed in a third region R3 between the first region R1 and the second region R2. For example, a first bias cell C71, a second bias cell C72, a third bias cell C73, and a fourth bias cell C74 may be disposed in the first row ROW1, the second row ROW2, the third row ROW3, and the fourth row ROW4, respectively. As described above with reference to FIG. 4, it may not be easy to make the width of the doping region less than a height H. Accordingly, as illustrated in FIG. 6A, each of the N-doping region and the P-doping region may have a shape in which the N-doping region or the P-doping region may have lengths in the X-axis direction and the Y-axis direction, the lengths being greater than or equal to the height H. A length of the third region R3 in the X-axis direction, that is, a width of the first bias cell C71, the second bias cell C72, the third bias cell C73, and the fourth bias cell C74 may be correspond to a third length L3, and the third length L3 may be equal to the second length L2 of FIGS. 6A and 6B and less than the first length L1 of FIGS. 5A and 5B.

In comparison with the example of FIG. 6A, the doping regions of the third region R3 of FIG. 7 may not be aligned (or overlap) in the rows. For example, the N-doping regions in the third region R3 of FIG. 6A may include portions shifted from the N-doping regions of the first region R1 and the second region R2 in a -Y-axis direction, and the shifted portion may be aligned (or overlap) in each of boundaries of the first row ROW1, the second row ROW2, the third row ROW3, and the fourth row ROW4. Also, the P-doping regions in the third region R3 in FIG. 6A may include portions shifted from the P-doping regions of the first region R1 and the second region R2 in the -Y-axis direction, and the shifted portion may be aligned (or overlap) in each of the boundaries of the first row ROW1, the second row ROW2, the third row ROW3, and the fourth row ROW4. The N-doping regions in the third region R3 of FIG. 7 may include portions shifted from the N-doping regions of the first region R1 and the second region R2 in a -Y-axis direction, and the shifted portion may not be aligned (or overlap) in each of boundaries of the first row ROW1, the second row ROW2, the third row ROW3, and the fourth row ROW4. Also, the P-doping regions in the third region R3 of FIG. 7 may include portions shifted from the P-doping regions of the first region R1 and the second region R2 in the -Y-axis direction, and the shifted portion may not be aligned (or overlap) in each of the boundaries of the first row ROW1, the second row ROW2, the third row ROW3, and the fourth row ROW4.

FIG. 8 is a plan view of a layout 80 of an integrated circuit according to one or more embodiments. For example, the plan view of FIG. 8 shows the layout 80 including a bias cell including a diffusion break. In the descriptions with respect to FIG. 8, aspects that are the same as described above with reference to the drawings are not repeatedly described.

Referring to FIG. 8, a first row ROW1, a second row ROW2, a third row ROW3, and a fourth row ROW4 may extend in an X-axis direction. Functional cells may be disposed in a first region R1 and a second region R2, and bias cells may be disposed in a third region R3 between the first region R1 and the second region R2. For example, four bias cells may be disposed in the first row ROW1, the second row ROW2, the third row ROW3, and the fourth row ROW4, respectively. The layout 80 may include a substrate SUB and a first well W81 and a second well W82 extending on the substrate SUB in the X-axis direction in parallel with each other. Also, as described above with reference to the drawings, the layout 80 may include doped regions. The layout 80 may include gate electrodes extending in a Y-axis direction. As illustrated in FIG. 8, the gate electrodes may extend in the Y-axis direction by a contacted poly pitch (CPP).

According to some embodiments, the layout 80 may include, in the third region R3, one or more diffusion breaks adjacent to (e.g. abutting) the first region R1 and extending in the Y-axis direction and one or more diffusion breaks adjacent to (e.g. abutting) the second region R2 and extending in the Y-axis direction. For example, as illustrated in FIG. 8, a first diffusion break FC1, a second diffusion break FC2, and a third diffusion break FC3 which are adjacent to the first region R1 may extend in the Y-axis direction in the third region R3. Also, a fourth diffusion break FC4, a fifth diffusion break FC5, and a sixth diffusion break FC6 which are adjacent to the second region R2 may extend in the Y-axis direction in the third region R3. Accordingly, the four bias cells may respectively include portions of the one or more diffusion breaks adjacent to the first region R1 and extending in the Y-axis direction, that is, the first diffusion break FC1, the second diffusion break FC2, or the third diffusion break FC3. Also, the four bias cells may respectively include portions of the one or more diffusion breaks adjacent to the second region R2 and extending in the Y-axis direction, that is, the fourth diffusion break FC4, the fifth diffusion break FC5, or the sixth diffusion break FC6.

According to some embodiments, each of the first diffusion break FC1, the second diffusion break FC2, the third diffusion break FC3, the fourth diffusion break FC4, the fifth diffusion break FC5, and the sixth diffusion break FC6 may be a double diffusion break (DDB). For example, as illustrated in FIG. 8, each of the first diffusion break FC1, the second diffusion break FC2, the third diffusion break FC3, the fourth diffusion break FC4, the fifth diffusion break FC5, and the sixth diffusion break FC6 may correspond to a region between adjacent gate electrodes. According to some embodiments, the gate electrodes adjacent to the first diffusion break FC1, the second diffusion break FC2, the third diffusion break FC3, the fourth diffusion break FC4, the fifth diffusion break FC5, and the sixth diffusion break FC6 may be filled with an insulator and may be referred to as dummy gate electrodes. According to some embodiments, the functional cells adjacent to each other in the X-axis direction in the first region R1 and the second region R2 may be separated from each other by a single diffusion break (SDB), and the SDB may have a width (that is, a length in the X-axis direction) corresponding to one gate electrode and may extend in the Y-axis direction.

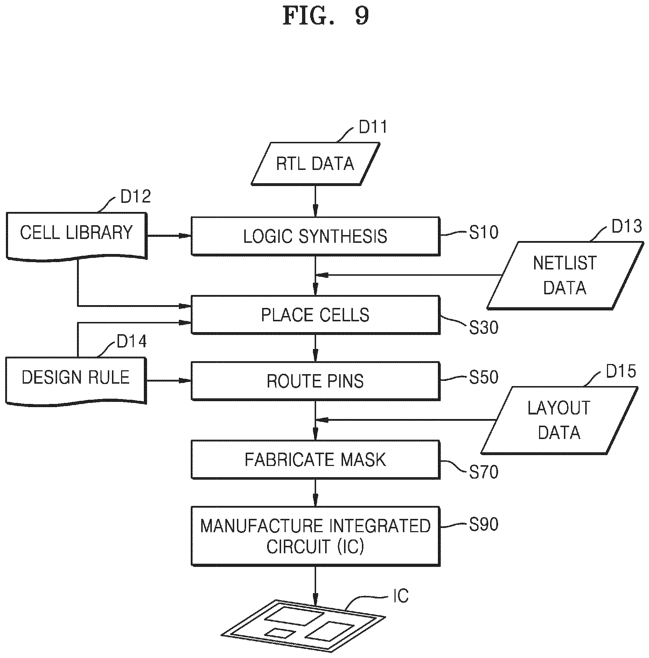

FIG. 9 is a flowchart of a method of manufacturing an integrated circuit (IC), according to one or more embodiments. In detail, the flowchart of FIG. 9 shows an example of a method of manufacturing the IC including standard cells. As illustrated in FIG. 9, the method of manufacturing the IC may include a plurality of operations S10, S30, S50, S70, and S90.

A cell library (or a standard cell library) D12 may include information about the standard cells, for example, information about a function, a characteristic, a layout, etc. According to some embodiments, the cell library D12 may not only define function cells generating an output signal from an input signal, but may also define bias cells. For example, the cell library D12 may include a bias cell including a P+ region to bias a substrate, a bias cell including an N+ region to bias a well, and a bias cell including the P+ region and the N+ region to bias both of the substrate and the well. As described above with reference to the drawings, the bias cells may have a structure corresponding to a doping region easily implemented. Also, the bias cells may have reduced widths, and thus, an area of the IC may be reduced.

A design rule D14 may include requirements to be met by a layout of the integrated circuit IC. For example, the design rule D14 may include requirements with respect to a space between patterns in the same layer, a minimum width of a pattern, a routing direction of a wiring layer, etc. According to some embodiments, the design rule D14 may define a minimum width of an active pattern, a minimum distance between the active patterns, etc.

In operation S10, a logic synthesis operation for generating netlist data D13 from RTL data D 11 may be performed. For example, a semiconductor design tool (for example, a logic synthesis tool) may perform logic synthesis based on the RTL data D11 composed in a hardware description language (HDL), such as a VHSIC hardware description language (VHDL) and Verilog, by referring to the cell library D12, and thus may generate the netlist data D13 including a bitstream or a netlist. The netlist data D13 may correspond to an input of placing and routing described below. Herein, the netlist data D13 may be referred to as input data.

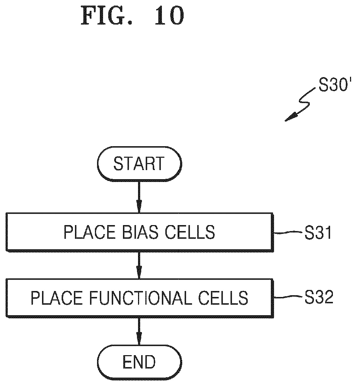

In operation S30, the cells may be placed. For example, the semiconductor design tool (for example, a P&R tool) may place the cells used in the netlist data D13 with reference to the cell library D12 and the design rule D14. Also, the semiconductor design tool may place not only the cells used in the netlist data D13 but also the bias cells, with reference to the cell library D12 and the design rule D14. An example of operation S30 is described below with reference to FIG. 10.

In operation S50, pins of the cells may be routed. For example, the semiconductor design tool may generate interconnections electrically connecting output pins with input pins of the placed functional cells. Also, the semiconductor design tool may generate interconnections connecting the pins of the bias cells, that is, doped regions, to a power node, for example, a node to which a positive supply voltage is applied or a node to which a negative supply voltage is applied. The interconnection may include a via of a via layer and/or a pattern of a wiring layer. The semiconductor design tool may generate layout data D15 defining the placed cells and the generated interconnections. The layout data D15 may have, for example, a format such as GDSII and may include geometric information of the cells and the interconnections. The semiconductor design tool may refer to the design rule D14 while routing the pins of the cells. The layout data D15 may correspond to an output of the placing and the routing. Operation S50 may be solely referred to as a method of designing or manufacturing an integrated circuit, or operations S30 and S50 may be collectively referred to as the same.

In operation S70, an operation of manufacturing a mask may be performed. For example, optical proximity correction (OPC) for correcting distortion, such as refraction, due to the characteristics of light in photolithography may be applied to the layout data D15. To form patterns placed on a plurality of layers based on the data to which the OPC is applied, patterns on a mask may be defined, and at least one mask (or photomask) for forming the patterns of each of the plurality of layers may be fabricated. According to some embodiments, a layout of the IC may be changed in operation S70 in a limited way, and the changing of the IC in the limited way in operation S70 may indicate a post process for optimizing a structure of the IC and may be referred to as design polishing.

In operation S90, an operation of manufacturing the IC may be performed. For example, the plurality of layers may be patterned by using the at least one mask fabricated in operation S70 to manufacture the IC. A front-end-of line (FEOL) may include, for example, planarization and cleaning of a wafer, formation of a trench, formation of a well, formation of a gate electrode, and formation of a source and a drain, and by the FEOL, individual devices, for example, a transistor, a capacitor, a resistor, etc. may be formed on the substrate. Also, a back-end-of-line (BEOL) may include, for example, silicidation of a gate and source and drain regions, addition of a dielectric, planarization, formation of a hole, addition of a metal layer, formation of a via, formation of a passivation layer, etc., and by the BEOL, individual devices, for example, a transistor, a capacitor, a resistor, etc. may be connected to each other. According to some embodiments, a middle-of-line (MOL) may be performed between the FEOL and the BEOL, and contacts may be formed in the individual devices. Thereafter, the IC may be packaged in a semiconductor package and may be used as a component of various applications.

FIG. 10 is a flowchart of a method of manufacturing an IC, according to one or more embodiments. In detail, the flowchart of FIG. 10 illustrates an example of operation S30 in FIG. 9. As described above with reference to FIG. 9, in operation S30' of FIG. 10, cells may be placed. As illustrated in FIG. 10, operation S30' may include operation S31 and operation S32. Hereinafter, FIG. 10 is described by referring to FIG. 9.

Referring to FIG. 10, in operation S31, the bias cells may be placed. As described above with reference to the drawings, the bias cells may bias the substrate and/or the well, and to this end, the bias cells may include a doped region. The bias cells may be regularly placed in a layout of the integrated circuit, in order that potentials of the substrate and the wells may be uniformly formed. For example, as described above with reference to FIG. 1, columns (for example, the first column COL1, the second column COL2, and the third column COL3 of FIG. 1) each including a series of bias cells may be placed in the layout of the IC, and according to some embodiments, distances between the columns may be constant.

According to some embodiments, the cell library D12 may define a first bias cell to bias the substrate and a second bias cell to bias the well. The first bias cell may include a P+ region disposed on the substrate, and the second bias cell may include an N+ region disposed on the well. The semiconductor design tool may identify regions in which the bias cells are to be placed, for example, the columns, and may alternately place a plurality of first bias cells and a plurality of second bias cells in the identified columns, with reference to the design rule D14. Accordingly, due to the reduced widths of the first bias cell and the second bias cell, areas of the regions in which the bias cells are placed may be reduced, and as a result, an area of the IC may be reduced. According to some embodiments, each of the first bias cell and the second bias cell may include one or more diffusion breaks.

In operation S32, functional cells may be placed. For example, the semiconductor design tool may identify the functional cells with reference to the netlist data D13, and in operation S32, may place the functional cells in regions except for the regions in which the bias cells are placed. The functional cell may include a transistor, and a source/drain region of the transistor may correspond to a doped region. For example, the N+ region disposed on the substrate may correspond to a source/drain of an NFET, and the P+ region disposed on the well may correspond to a source/drain of a PFET.

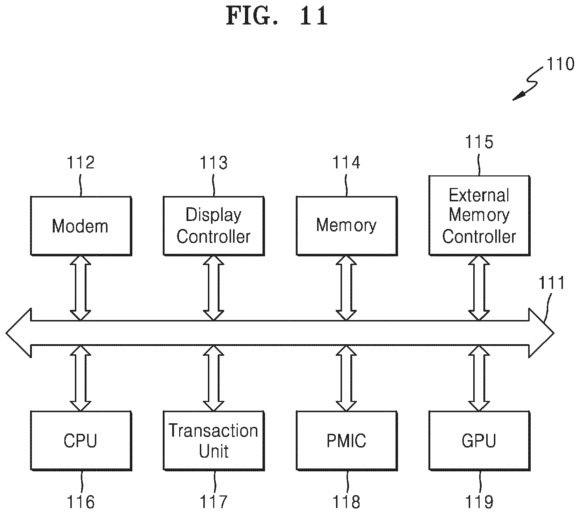

FIG. 11 is a block diagram of a system on chip (SoC) 110 according to one or more embodiments. The SoC 110 may be a semiconductor device, and the SoC 110 may include an integrated circuit according to one or more embodiments. The SoC 110 may be a single chip in which complex blocks are implemented, such as intellectual property (IP) blocks configured to perform various functions. The SoC 110 may be designed by a method of manufacturing an integrated circuit, according to embodiments, and thus, the SoC 110 may have a reduced area. Referring to FIG. 11, the SoC 110 may include a modem 112, a display controller 113, a memory 114, an external memory controller 115, a central processing unit (CPU) 116, a transaction unit 117, a power management integrated circuit (PMIC) 118, and a graphics processing unit (GPU) 119, and each of the functional blocks of the SoC 110 may communicate with one another through a system bus 111.

The CPU 116 configured to control operation of the SoC 110 at an uppermost level may control operation of the other functional blocks 112 to 119. The modem 112 may demodulate a signal received from the outside of the SoC 110 or may modulate a signal generated in the SoC 110 and transmit the modulated signal to the outside. The external memory controller 115 may control an operation of transmitting and receiving data to and from an external memory device connected to the SoC 110. For example, a program and/or data stored in the external memory device may be provided to the CPU 116 or the GPU 119 under control by the external memory controller 115. The GPU 119 may execute program instructions related to graphics processing. The GPU 119 may receive graphics data through the external memory controller 115 or may transmit graphics data processed by the GPU 119 to the outside of the SoC 110 through the external memory controller 115. The transaction unit 117 may monitor data transaction of each functional block, and the PMIC 118 may control power supplied to each functional block according to control by the transaction unit 117. The display controller 113 may control a display (or a display device) outside the SoC 110 to transmit data generated in the SoC 110 to the display. The memory 114 may include nonvolatile memory, such as electrically erasable programmable read-only memory (EEPROM), flash memory, etc., and may include volatile memory, such as dynamic random-access memory (DRAM), static random-access memory (SRAM), etc.

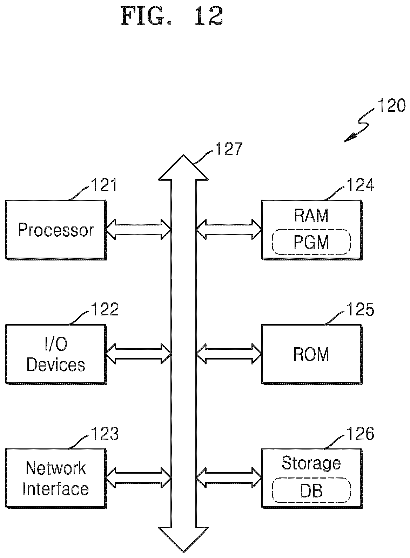

FIG. 12 is a block diagram of a computing system 120 including a memory storing a program, according to one or more embodiments. At least a portion of the method of manufacturing the integrated circuit, according to embodiments, for example, at least one of operations of the flowchart described above may be performed in the computing system (or a computer) 120.

The computing system 120 may be a fixed-type computing system, such as a desktop computer, a workstation, a server, etc., or may be a portable computing system, such as a laptop computer, etc. As illustrated in FIG. 12, the computing system 120 may include a processor 121, input and output (I/O) devices 122, a network interface 123, a random-access memory (RAM) 124, a read-only memory (ROM) 125, and a storage 126. The processor 121, the input and output devices 122, the network interface 123, the RAM 124, the ROM 125, and the storage 126 may be connected to a bus 127 and may communicate with one another through the bus 127.

The processor 121 may be referred to as a processing unit and may include at least one core configured to execute an arbitrary instruction set (for example, Intel architecture (IA)-32, 64-bit expansion IA-32, x86-64, PowerPC, Scalable Processor Architecture (Sparc), Million Instructions Per Second (MIPS), Advanced RISC Machine (ARM), IA-64, etc.), such as a micro-processor, an application processor (AP), a digital signal processor (DSP), and a GPU. For example, the processor 121 may access a memory, that is, the RAM 124 or the ROM 125 through the bus 127 and may execute instructions stored in the RAM 124 or the ROM 125.

The RAM 124 may store a program PGM for the method of manufacturing the integrated circuit, according to one or more embodiments, or at least part of the program PGM, and through the program PGM, the processor 121 may perform at least one of the operations of the method of manufacturing the integrated circuit, for example, the method of FIG. 9. That is, the program PGM may include a plurality of instructions executable by the processor 121, and the plurality of instructions included in the program PGM may allow the processor 121 to perform at least one of the operations included in the flowcharts described above.

The storage 126 may not lose data stored even when a power supply to the computing system 120 is blocked. For example, the storage 126 may include a nonvolatile memory device and may include a storage medium such as a magnetic tape, an optical disk, or a magnetic disk. Also, the storage 126 may be detachable from the computing system 120. The storage device 126 may store the program PGM according to one or more embodiments, and before the program PGM is executed by the processor 121, the program PGM or at least part of the program PGM may be loaded from the storage 126 to the RAM 124. Alternatively, the storage 126 may store a file composed in a program language, and the program PGM generated by a compiler, etc. or at least part of the program PGM may be loaded from the file to the RAM 124. Also, as illustrated in FIG. 12, the storage 126 may store a database DB, and the database DB may include information necessary to design an integrated circuit, for example, information with respect to designed blocks, and the cell library D12 and/or the design rule D14 of FIG. 9.

The storage 126 may store data to be processed by the processor 121 or data processed by the processor 121. That is, the processor 121 may generate data by processing the data stored in the storage 126 or may store the generated data in the storage 126, according to the program PGM. For example, the storage 126 may store the RTL data D11, the netlist data D13, and/or the layout data D15 of FIG. 9.

The input and output devices 122 may include an input device, such as a keyboard, a pointing device, etc., and may include an output device, such as a display device, a printer, etc. For example, a user may trigger execution of the program PGM by the processor 121 through the input and output devices 122, may input the RTL data D11 and/or the netlist data D13 of FIG. 9, and may identify the layout data D15 of FIG. 9.

The network interface 123 may provide access to a network outside the computing system 120. For example, the network may include a plurality of computing systems and communication links, and the communication links may include wired links, optical links, wireless links, or other arbitrary forms of links.

While certain embodiments of the disclosure have been particularly shown and described, it will be understood that various changes in form and details may be made therein without departing from the scope of the following claims.

## Claims

1. An integrated circuit comprising:
a plurality of wells (W11, W12; W41, W42; W51, W52; W61, W62; W81, W82) extending in parallel with each other in a first direction (X) on a substrate (SUB) having a first conductivity type, the plurality of wells (W11, W12; W41, W42; W51, W52; W61, W62; W81, W82) having a second conductivity type;
a plurality of first doped regions (P1 1-P14, P21-P24) disposed on the plurality of wells (W1 1, W12; W41, W42; W51, W52; W61, W62; W81, W82) in a first region (R1) and a second region (R2) of the substrate (SUB), the first region (R1) being separated from the second region (R2) in the first direction (X), and the plurality of first doped regions (P11-P14, P21-P24) having the first conductivity type;
a plurality of second doped regions (N12, N13, N22, N23) disposed on the substrate (SUB) between the plurality of wells (W11, W12; W41, W42; W51, W52; W61, W62; W81, W82) in the first region (R1) and the second region (R2), the plurality of second doped regions (N12, N13, N22, N23) having the second conductivity type;
a plurality of third doped regions (P31-P34) disposed in a third region (R3) of the substrate (SUB) between the first region (R1) and the second region (R2) and having the first conductivity type; and
a plurality of fourth doped regions (N31, N32, N33, N34) disposed on the plurality of wells (W11, W12; W41, W42; W51, W52; W61, W62; W81, W82) in the third region (R3) and having the second conductivity type,
wherein the third region (R3) extends in a second direction (Y) perpendicular to the first direction (X).

2. The integrated circuit of claim 1, wherein the plurality of third doped regions (P31-P34) comprise at least one third doped region at least partially overlapping at least one second doped region from among the plurality of second doped regions (N12, N13, N22, N23) in the first direction (X).

3. The integrated circuit of claim 2, wherein the at least one third doped region overlaps the at least one second doped region in the first direction (X).

4. The integrated circuit of any one of claims 1 to 3, wherein the plurality of fourth doped regions (N31, N32, N33, N34) comprise at least one fourth doped region at least partially overlapping at least one first doped region from among the plurality of first doped regions (P11-P14, P21-P24) in the first direction (X).

5. The integrated circuit of claim 4, wherein the at least one fourth doped region overlaps the at least one first doped region in the first direction (X).

6. The integrated circuit of any one of claims 1 to 5, further comprising:
at least one first double diffusion break, DDB, (FC1) in the third region (R3), the at least one first DDB abutting the first region (R1) and extending in the second direction (Y); and
at least one second DDB in the third region (R3), the at least one second DDB (FC6) abutting the second region (R2) and extending in the second direction (Y).

7. The integrated circuit of any one of claims 1 to 6,
wherein the plurality of first doped regions (P11-P14, P21-P24) and the plurality of third doped regions (P31-P34) each have a doping concentration of the first conductivity type and greater than a doping concentration of the substrate (SUB), and
wherein the plurality of second doped regions (N12, N13, N22, N23) and the plurality of fourth doped regions (N31, N32, N33, N34) each have a doping concentration of the second conductivity type and greater than a doping concentration of the plurality of wells (W11, W12; W41, W42; W51, W52; W61, W62; W81, W82).

8. The integrated circuit of any one of claims 1 to 7,
wherein the substrate (SUB) is configured to be biased to a first supply voltage through the plurality of third doped regions (P31-P34), and
wherein the plurality of wells (W11, W12; W41, W42; W51, W52; W61, W62; W81, W82) are configured to be biased to a second supply voltage through the plurality of fourth doped regions (N31, N32, N33, N34).

9. A method of manufacturing an integrated circuit, the method comprising:
placing bias cells (C51, C52, C53, C54; C61, C62, C63, C64; C71, C72, C73, C74) for biasing a substrate (SUB) and a plurality of wells (W11, W12; W41, W42; W51, W52; W61, W62; W81, W82), the substrate (SUB) having a first conductivity type and the plurality of wells (W11, W12; W41, W42; W51, W52; W61, W62; W81, W82) extending on the substrate (SUB) in parallel with each other in a first direction (X) and having a second conductivity type; and
placing, based on input data, functional cells in a region of the substrate (SUB) in which the bias cells (C51, C52, C53, C54; C61, C62, C63, C64; C71, C72, C73, C74) are not placed,
wherein the placing of the bias cells comprises alternately placing a plurality of first bias cells (C51, C52, C53, C54; C61, C62, C63, C64; C71, C72, C73, C74) biasing the substrate (SUB) and a plurality of second bias cells biasing the plurality of wells (W11, W12; W41, W42; W51, W52; W61, W62; W81, W82) in a second direction (Y) perpendicular to the first direction (X).

10. The method of claim 9, wherein each of the plurality of first bias cells comprises a doped region placed on the substrate (SUB) between the plurality of wells (W11, W12; W41, W42; W51, W52; W61, W62; W81, W82) and having the first conductivity type.

11. The method of claim 9 or 10, wherein each of the plurality of second bias cells comprises a doped region placed on the plurality of wells (W11, W12; W41, W42; W51, W52; W61, W62; W81, W82) and having the second conductivity type.

12. The method of any one of claims 9 to 11, wherein each of the plurality of first bias cells and the plurality of second bias cells comprises at least one double diffusion break, DDB, abutting the functional cells and extending in the second direction (Y).
